Europäisches Patentamt

European Patent Office

Office européen des brevets

(19)

(11) Veröffentlichungsnummer : **0 101 611**
**B1**

(12) **EUROPÄISCHE PATENTSCHRIFT**

(45) Veröffentlichungstag der Patentschrift :
**01.02.89**

(21) Anmeldenummer : **83108148.4**

(22) Anmeldetag : **17.08.83**

(51) Int. Cl.⁴ : **H 03 D 9/06**, H 03 C 7/02,
**H 03 B 9/14**, H 04 B 1/40

(54) Sender/Empfänger-Modul.

(30) Priorität : **19.08.82 DE 3230832**

(43) Veröffentlichungstag der Anmeldung :
**29.02.84 Patentblatt 84/09**

(45) Bekanntmachung des Hinweises auf die Patenterteilung : **01.02.89 Patentblatt 89/05**

(84) Benannte Vertragsstaaten :
**DE FR GB IT NL SE**

(56) Entgegenhaltungen :
CONFERENCE PROCEEDINGS - 12th EUROPEAN
MICROWAVE CONFERENCE, 13.-17. September
1982, Helsinki, Finnland, Seiten 702-706; E. KPODZO
u.a.: "Integrated fin-line MM-wave transceiver"
IDEM
1982 IEEE MTT-S INTERNATIONAL MICROWAVE
SYMPOSIUM DIGEST, 15.-17. Juni 1982, Dallas,
Texas, Seiten 231-232, IEEE, New York, US; A.
HISLOP: "A compact low cost 60 GHZ communicator"
IEEE TRANSACTIONS ON MICROWAVE THEORY
AND TECHNIQUES, Band MTT-28, Nr. 7, Juli 1980,
Seiten 747-752, IEEE, New York, US; E. KPODZO u.a.:
"A quadriphase fin-line modulator"
CONFERENCE PROCEEDINGS - 10th EUROPEAN
MICROWAVE CONFERENCE, 8.-12. September 1980,
Warschau, Polen, Seiten 750-753, Sevenoaks, Kent,
GB; G. BEGEMANN u.a.: "A Ku-band fin-line frontend with a hybrid-coupled balanced mixer and a gunn
oscillator"
CONFERENCE· PROCEEDINGS - 12th EUROPEAN
MICROWAVE CONFERENCE, 13.-17. September
1982, Helsinki, Finnland, Seiten 687-690, Microwave
Exhibitions and Publishers Ltd.; K. ERICHSEN u.a.:
"MM-wave fin-line oscillator with electronic matching
and tuning"

(73) Patentinhaber : **ALCATEL N.V.**
**Strawinskylaan 537 (World Trade Center)**
**NL-1077 XX Amsterdam (NL)**
**FR GB IT NL SE**
**Standard Elektrik Lorenz Aktiengesellschaft**
**Hellmuth-Hirth-Strasse 42**
**D-7000 Stuttgart 40 (DE)**
**DE**

(72) Erfinder : **Szabo, Laszlo, Dr.-Ing.**
**Tubizer Strasse 11**
**D-7015 Korntal (DE)**

(74) Vertreter : **Schmidt, Werner, Dipl.-Phys. et al**
**Standard Elektrik Lorenz AG Patent- und Lizenzwe-**
**sen Postfach 30 09 29**
**D-7000 Stuttgart 30 (DE)**

IEEE TRANSACTIONS ON MICROWAVE THEORY AND TECHNIQUES, Band MTT-18, Nr. 11, November 1970, Seiten 827-834, IEEE, New York, US; J.F. FEYNOLDS u.a.: "Microwave circuits for high-efficiency operation of transferred electron oscillators"
CONFERENCE PROCEEDINGS - 11th EUROPEAN MICROWAVE CONFERENCE, 7.-11. September 1981, Amsterdam, Holland, Seiten 301-304; HADIA EL HENNAWY u.a.: "Octave-band fin-line hybrid"

**Beschreibung**

Die Erfindung geht aus von einem Sender/Empfänger-Modul wie im Oberbegriff der Ansprüche 1 und 2 angegeben. Ein solcher Sender/Empfänger-Modul ist aus dem Aufsatz « A Compact 60-GHz Transmitter-Receiver » von Y. Matsuo et al in IEEE Transactions on Microwave Theory and Techniques, Bd. MTT-24, Nr. 11, November 1976, Seiten 794-797 bekannt.

Bei der Realisierung eines solchen Sender/Empfängers für Frequenzen im GHz-Bereich treten zahlreiche Probleme auf, insbesondere hinsichtlich einer guten Reproduzierbarkeit, weil bei einer Serienproduktion die erlaubten Fertigungstoleranzen sehr klein gehalten werden müssen.

Die neuen Sender/Empfänger-Module gemäß den Ansprüchen 1 und 2 sowie den Weiterbildungen nach den Ansprüchen 3-5 sind sehr gut für eine Serienfertigung geeignet. Sie sind gegen Fertigungstoleranzen relativ unempfindlich und preiswert herzustellen. Ihr Platzbedarf ist sehr gering, wodurch ein hoher Integrationsgrad möglich ist.

Die Erfindung wird anhand der Zeichnungen beispielsweise näher erläutert. Es zeigt :

Fig. 1 ein Blockschaltbild des bekannten Sender/Empfänger-Moduls,

Fig. 2 ein Ausführungsbeispiel für einen Mischer/Modulator für den Sender/Empfänger-Modul,

Fig. 3 ein Ausführungsbeispiel für einen Koppler für den Sender/Empfänger-Modul,

Fig. 4, 5 Ausführungsbeispiele für Oszillatoren für den Sender/Empfänger-Modul, und

Fig. 6, 7 Blockschaltbilder für Oszillatoren, die besonders gut zur Realisierung in Streifenleitungstechnik geeignet sind.

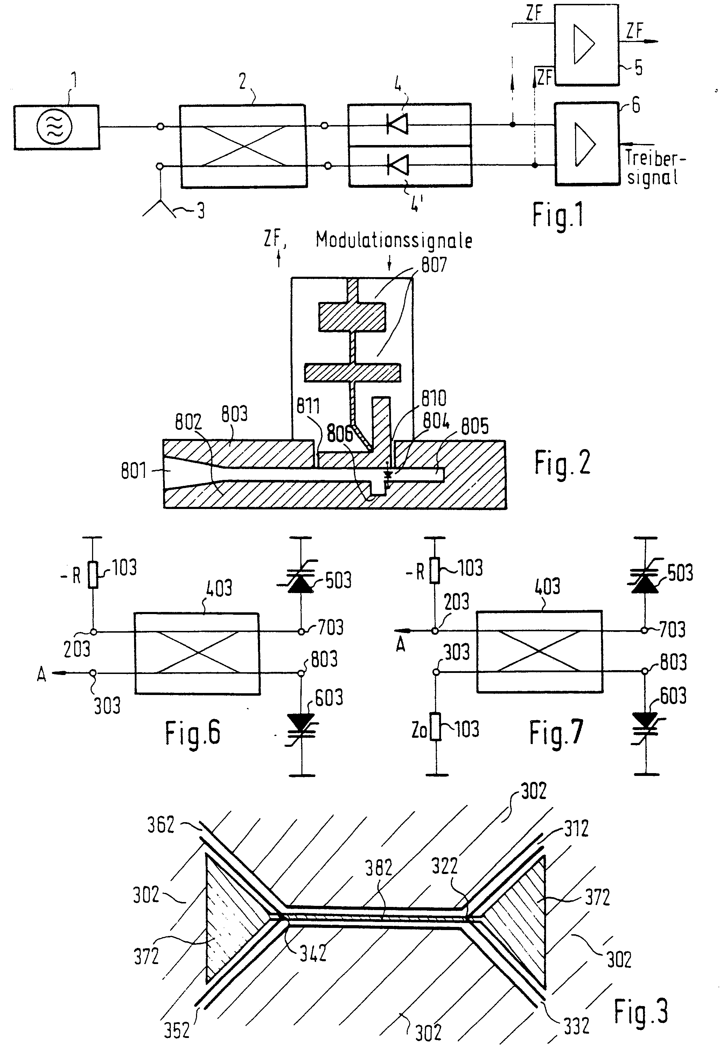

Anhand der Fig. 1 wird zunächst das Blockschaltbild des bekannten Sender/Empfänger-Moduls erläutert.

Es ist ein Koppler 2, realisiert als 3dB-Hybrid, vorgesehen. Gleiche Ergebnisse erzielt man, wenn man anstelle des Kopplers ein magisches T verwendet. Der Koppler hat vier Anschlüsse. An einen ersten Anschluß ist ein Oszillator 1, an einen zweiten eine Antenne 3, und an die beiden restlichen Anschlüssen jeweils eine Diode 4,4' angeschlossen. Die Dioden sind einerseits mit einer ZF-Verstärkerstufe 5 und andererseits mit einer Treiberstufe 6 verbunden. Beim Sendebetrieb arbeitet der Oszillator 1 als Sendeoszillator und die Dioden 4,4' sind als Modulator eingesetzt. Die Treiberstufe 6 steuert die Vorspannung der Dioden entsprechend der gewünschten Modulation. Die modulierten Signale werden im Koppler addiert und der Antenne 3 zugeführt. Antenne und Oszillator müssen voneinander entkoppelt sein. Das wird erreicht durch die Isolation des Kopplers und durch eine zwischen Koppler und Oszillator eingefügte Richtungsleitung oder Dämpfungsglied (in Fig. 1 nicht dargestellt).

Beim Empfangsbetrieb arbeitet der Oszillator 1 als Mischeroszillator und die Dioden 4,4' sind als Mischer eingesetzt. In der ZF-Verstärkerstufe 5 erfolgt eine Vorverstärkung des ZF-Signals. Das von der Antenne 3 aufgenommene Signal wird vom Koppler 2 auf die beiden Dioden 4,4' aufgeteilt.

Modulator und Mischer sind also eine Baueinheit. Als Dioden eignen sich Schottky-Dioden.

Diese Schaltung läßt sich in besonders vorteilhafter Weise in Flossenleitungstechnik realisieren. Der Sender/Empfänger-Modul kann dann mit einem hohen Integrationsgrad sehr kompakt und sowohl mechanisch als auch elektrisch stabil gebaut werden.

Bei der an sich bekannten Flossenleitungs-Technik erfolgt die Wellenausbreitung in einem Hohlleiter, in dem ein dielektrisches Substrat vorgesehen ist, auf das metallische Flossen aufgebracht sind. Die Ausbreitungseigenschaften werden im wesentlichen durch die Flossen bestimmt.

Zwecks besserer Übersichtlichkeit werden nachfolgend der Oszillator, der Koppler, der Mischer/Modulator und die Antenne voneinander unabhängig beschrieben. Diese Baugruppen weisen jedoch alle Eingänge bzw. Ausgänge auf, die in Flossenleitungstechnik realisiert sind, so daß diese Bauelemente leicht miteinander verbunden werden können.

Anhand der Fig. 2 wird zunächst der Mischer/Modulator 4 näher erläutert. Die Zeichnung zeigt nur die Anordnung für eine Diode. Die Anordnung für die andere Diode ist mit dieser identisch.

Zwei auf ein Substrat aufgebrachte Flossen 802, 803 bilden einen Schlitz 801, der zur linken Seite hin etwas aufgeweitet ist. An dieser Stelle ist der Mischer/Modulator mit dem Koppler verbunden. Die Aufweitung dient zur Anpassung an den Koppler (bei gleichen Impedanzen ist keine Aufweitung notwendig).

Zur vollständigen Anpassung (Realteil und Imaginärteil) weist der Schlitz der Flossenleitung noch eine Aussparung 806 auf, deren Bemessung dem Fachmann bekannt ist. Hinter dieser Aussparung 806 ist die Schottky-Diode 804 angeordnet, und zwar so, daß sie mit den beiden Flossen 802, 803 der Flossenleitung verbunden ist. Der Schlitz ist über die Schottky-Diode 806 hinaus noch um ein bestimmtes Stück 805 verlängert und bildet an seinem Ende für die Wellenausbreitung einen Kurzschluß.

Die Auskopplung des ZF-Signals erfolgt über eine Streifenleitung 807, die als Tiefpaß ausgebildet ist. Die Streifenleitung ist mit der Flosse 803 leitend verbunden. Die Flosse 803 weist beidseitig von der Verbindungsstelle Schlitze 810, 811 auf, die eine galvanische Trennung der beiden Diodenanschlüsse bewirken. Die Schlitze sind so schmal, daß sie die Wellenausbreitung in der Flossenleitungsebene nicht wesentlich beeinflussen.

Für die Zuführung der Modulationssignale gilt das für die Auskopplung des ZF-Signals gesagte sinngemäß.

Die Wirkungsweise des Mischer/Modulators ist wie folgt : Eine Schottky-Diode ist in erster Näherung ein rein resistives Bauelement. Die Blindanteile ihrer Impedanz, die durch das Gehäuse und durch die kurzgeschlossene Stichleitung 805 hinter der Diode 804 herausgestimmt. Ohne Vorspannung oder bei leicht negativer Vorspannung ist die Diode relativ hochohmig. Die Diode absorbiert jetzt beim Modulatorbetrieb die einfallende Leistung, so daß praktisch keine reflektierte Welle entsteht. Spannt man die Diode positiv vor, dann verringert sich ihr Wirkwiderstand. Dadurch wird bei der Verwendung als Modulator die gesamte Hochfrequenzleistung reflektiert.

Beim Mischerbetrieb gelangt auf die Dioden 4,4' jeweils eine Hälfte des empfangenen Signals und des Mischeroszillatorsignals. Die von den Dioden erzeugten ZF-Signale werden zu der ZF-Verstärkerstufe 5 geleitet.

Für den Mischer/Modulator ist noch ein nicht dargestelltes und nicht in Flossenleitungstechnik realisiertes Versorgungsnetzwerk notwendig, das einerseits die erzeugten ZF-Signale der ZF-Verstärkerstufe zuleitet und andererseits die Modulationssignale zu den Dioden leitet.

Der 3dB-Koppler wird nachfolgend anhand der Fig. 3 erläutert. Bei dem Koppler handelt es sich um einen Koppler auf der Basis von Zweigleitungskopplern.

Die Flossenleitung des Kopplers ist unilateral, d. h. es sind nur auf einer Seite des Substrats metallische Flossen 302 auf das Substrat aufgebracht. Die Flossen sind in der Zeichnung durch eine Schraffur (von links unten nach rechts oben) gekennzeichnet. Die Flossen bilden Schlitze 312, 332, 352 und 362.

Der Schlitz zwischen den Punkten 322 und 342, an denen jeweils zwei unilaterale Flossenleitungen zusammentreffen, ist von seinem elektrischen Verhalten her kein Schlitz einer Flossenleitung sonder er bildet an sich eine Schlitzleitung.

Die beschriebene Flossenleitung stellt erst dann einen Koppler dar, wenn sie durch geeignet angeordnete quasikonzentrierte Elemente ergänzt wird. Hierzu ist geeignet :

ein Drahtstück (in der Fig. 3 nicht dargestellt), das an den Spitzen 322 und 342 auf die Flossen aufgebondet ist und somit diese beiden Spitzen verbindet. Das Drahtstück hat die Form eines U,

dessen Schenkel senkrecht zur Flossenoberfläche stehen und mit den Spitzen verbunden sind. Der zur Flossenoberfläche parallel angeordnete Teil des Drahtstücks soll von den Flossen einen möglichst großen Abstand haben, damit das elektrische Feld

der Flossenleitung möglichst wenig beeinflußt wird. Seine optimale Länge ist durch die erforderliche 90°-Phasenverschiebung zwischen den beiden Koppelarmen 31, 33 bestimmt.

ein auf der den Flossen gegenüberliegenden Seite des Substrats angeordneter Streifenleiter 382. Der Streifenleiter verläuft über dem Schlitz zwischen den Spitzen 322 und 342. Jeweils seitlich dieser Spitzen ist der Streifenleiter zu einer Metallfläche 372 aufgeweitet. Diese Metallflächen bilden mit den jeweils auf der anderen Substratseite angeordneten Flossen eine kapazitive Kopplung. Die Länge der Streifenleitung bestimmt die Entkopplung. Der Streifenleiter hat im allgemeinen keinen geraden sondern einen schlangenförmigen Verlauf, um, wie im vorhergehenden Fall, die 90°-Phasenverschiebung zu gewährleisten. Dadurch und weil die kapazitive Kopplung die elektrische Länge des Streifens beeinflußen kann diesem eine gewünschte elektrische Länge gegeben werden. Bei seiner Anordnung muß darauf geachtet werden, daß das elektrische Feld der Flossenleitung möglichst nicht beeinflußt wird und daß durch ihn keine bilaterale Flossenleitung gebildet wird.

Das Koppelverhältnis, d. h. das Verhältnis, in dem die über eine Flossenleitung zugeführte Energie auf die beiden Flossenleitungen, über die diese Energie weitergeleitet wird, aufgeteilt wird, hängt davon ab, wie stark die Flossenleitungen in ihrer Längsrichtung räumlich gegeneinander versetzt sind.

Der Koppler weist vier in Flossenleitungstechnik realisierte Anschlüsse auf, wobei die beiden rechten Anschlüsse mit den Flossenleitungen des Mischer/Modulators, die durch die Flossen 802, 803, den Schlitz 801 und den nicht dargestellten Hohlleiter gebildet werden, verbunden sind. Die beiden linken Anschlüsse sind an die Antenne 3 bzw. an den Oszillator 1 angeschlossen.

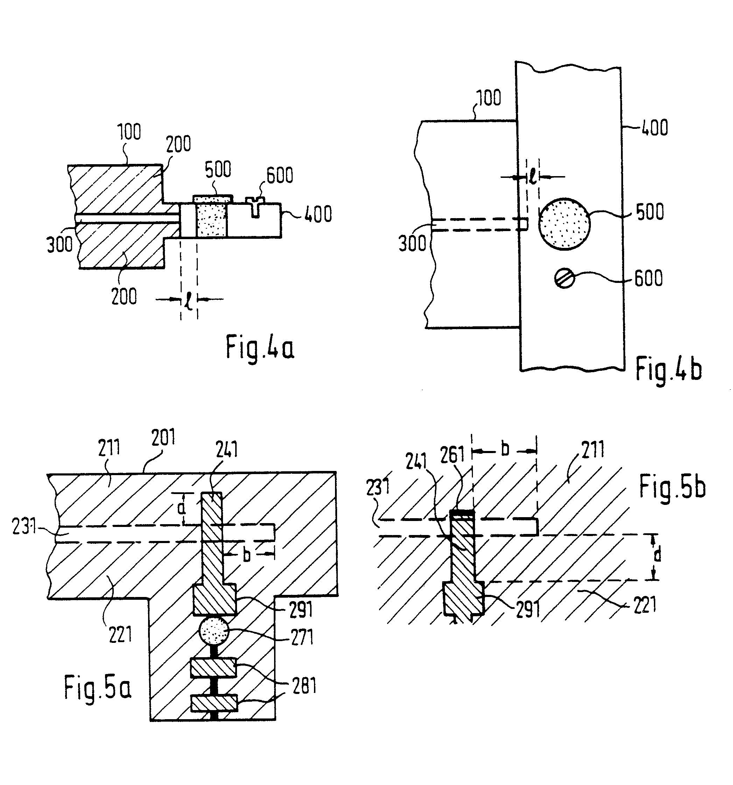

Nachfolgend werden anhand der Fig. 4 bis 7 Ausführungsbeispiele für Oszillatoren beschrieben.

Im Querschnitt der Fig. 4a sind im linken Teil das Hohlleitergehäuse 100 der Flossenleitung sowie die auf das Substrat aufgebrachte Flossen 200 dargestellt. Die Flossen lassen auf dem Substrat einen Schlitz 300 frei. Mit dem Hohlleitergehäuse 100 der Flossenleitung ist ein Sperrbereichshohlleiter 400 verbunden. Sperrbereichshohlleiter sind Hohlleiter, die in ihrem Sperrbereich betrieben werden, d. h. der Querschnitt des Hohlleiters ist so gewählt, daß die Grenzfrequenz der Grundwelle des Hohlleiters oberhalb der gewünschten Frequenz des Oszillators liegt. Die Flossen 200 ragen ein kleines Stück in den Sperrbereichshohlleiter hinein.

Das Diodengehäuse 500, in dem sich die Diode befindet, ist in an sich bekannter Weise in dem Sperrbereichshohlleiter angeordnet. Zur Realisierung einer bestimmten Kapazität ist im Sperrbereichshohlleiter 400 weiterhin eine Abstimmschraube 600 vorgesehen, die zusammen mit dem Gehäuse eine definierte Kapazität bildet.

Als Flossenleitung ist beim Ausführungsbeispiel eine unilaterale Flossenleitung gewählt. Der Schlitz liegt symmetrisch zwischen den Flossen. Es sind jedoch auch andere Flossenleitungen verwendbar, z. B. eine Flossenleitung, bei der der Schlitz durch nur eine Flosse und die Gehäusewand gebildet wird.

In der Fig. 4b ist eine Draufsicht auf diese Anordnung dargestellt. Die Bezugszeichen sind wie in Fig. 4a gewählt.

Nachfolgend wird kurz die Funktionsweise näher erläutert :

Der Sperrbereichshohlleiter ist im Ersatzschaltbild durch eine reine Induktivität darzustellen. Daher kann durch den Einbau des aktiven Elements kein unerwünschter Resonanzeffekt entstehen. Im Bereich des Sperrbereichshohlleiters gibt es keine Wellenausbreitung, so daß die Ersatzinduktivität als ein konzentriertes Schaltelement betrachtet werden kann. Man wählt die Breite des Sperrbereichshohlleiters so, daß die gewünschte Oszillationsfrequenz etwa 2/3 oder weniger der Grundfrequenz der Grundwelle beträgt. Dann ist die Ersatzinduktivität des Sperrbereichshohlleiters auch nahezu frequenzunabhängig.

Um die gewünschte Frequenz zu erzeugen, ist der komplementäre Energiespeicher, also eine Kapazität, hinzuzufügen. Dies geschieht bei diesem Ausführungsbeispiel auf zweierlei Weise : Einmal stellt die Auskoppelstelle, d. h. der Sprung von dem Flossenleitungsschlitz auf den Sperrbereichshohlleiter, im Ersatzschaltbild eine Parallelkapazität dar. Diese Kapazität ist jedoch recht klein,, da die metallischen Flossen sehr dünn (ca. 17,5 μm bis ca. 35 μm) sind. Damit läßt sich die induktive Reaktanz des Sperrbereichshohlleiters noch nicht kompensieren. Das geschieht durch eine weitere, größere Kapazität, die durch die Abstimmschraube im Sperrbereichshohlleiter realisiert wird. Damit kann zugleich die Frequenz des Oszillators mechanisch verändert werden. Der Sperrbereichshohlleiter muß in seinem rechten Bereich nicht unbedingt metallisch verschlossen sein, da hier nur aperiodisch gedämpfte Feldtypen existieren können.

Nachdem oben beschrieben wurde, wie die Frequenz eingestellt wird, wird nachfolgend beschrieben, wie Abstimmung auf die Last erfolgt. Hierzu muß der negative Ersatzwiderstand des aktiven Elements an den Verbraucher angepaßt werden. Als Freiheitsgrade bleiben einerseits die Schlitzbreite der Flossenleitung und andererseits der Abstand 1 zwischen dem Ende der Flossenleitung und dem Gehäuse des aktiven Elements übrig. Damit ist in jedem Fall eine eindeutige Anpassung möglich.

Die Versorgungsspannung für die Diode kann entweder in an sich bekannter Weise durch ein koaxiales Tiefpaßfilter zugeführt werden, oder aber — und diese Lösung ist der Struktur sehr gut angepaßt — durch einen dünnen Draht, der vom offenen Ende des Sperrbereichshohlleiters zur Diode geführt wird. Man muß dann dieses offene Ende nur mit dämpfendem Material zustopfen, damit hier keine Hochfrequenzleistung entweichen kann. Durch diese Maßnahme verringert sich die Ausgangsleistung nur unwesentlich (typisch um 0,2 dB), während man jedoch zwei weitere Vorteile gewinnt : Einmal wird die Anschwingsicherheit vergrößert, zum anderen der harmonische Gehalt des Ausgangsspektrums um typisch 10 dB abgesenkt. Wünscht man keine mechanische Durchstimmbarkeit des Oszillators, so kann die Abstimmschraube in einer Modifikation der Schaltung auch durch einen metallischen Streifen ersetzt werden, der durch Fotoätztechnik auf einem dielektrischen Substratmaterial erzeugt wird. Dazu hat man sich in Fig. 4a vorzustellen, daß das dielektrische Substrat, auf das im linken Teil die Flossen aufgebracht sind, sich auch rechts des aktiven Elementes befindet. Man kann dann auf der Kupferkaschierung dieses Substrates durch Ätzen einen longitudinalen, metallischen Streifen stehen lassen, der bei geeigneter Bemessung der Länge sowie der Höhe eine Kapazität darstellt. Auf diese Weise hat man eine rein planare Struktur realisiert und dabei die Diode billig, reproduzierbar und mit guter Wärmesenke eingebaut.

Man kann den Oszillator in vorteilhafter Weise durch Hinzufügen einer Varakterdiode zu einer elektronisch durchstimmbaren Komponente ergänzen. Dazu gibt es zwei Möglichkeiten : Einmal kann die Varakterdiode in einem normalen Gehäuse (z. B. S4-Gehäuse) in den Sperrbereichshohlleiter anstelle oder zusätzlich zur Abstimmschraube eingebaut werden. Die Halterung gleicht damit der des aktiven Elementes. Eine zweite Möglichkeit ist die, eine Varakterdiode in einem beam-lead Gehäuse an geeigneter Stelle direkt über den Flossenleitungs-Schlitz zu bonden. Man kann hier entlang des Schlitzes Orte finden, an denen die Varakterdiode so stark angekoppelt ist, daß der elektronische Durchstimmbereich Prozente beträgt. Dann verringert sich allerdings auch die Ausgangsleistung um 1 bis 3 dB. An anderen Orten ist dagegen die Ankopplung nur schwach, so daß man praktisch ohne Einbuße an Ausgangsleistung einen Durchstimmbereich in der Größenordnung von 3 % der Nennfrequenz realisieren kann.

Anhand der Fig. 5 wird ein weiteres Ausführungsbeispiel erläutert. Hier ist das Diodengehäuse nicht in einem Hohlleiter sondern in dem Substrat, auf das die Flossen der Flossenleitung aufgebracht sind, befestigt.

Bei der schematischen Darstellung in der Fig. 5a sind auf der Ober- und der Unterseite eines (nicht dargestellten) dielektrischen Substrates Metallisierungen aufgebracht. Metallisierungen auf der Substratunterseite sind durch eine Schraffur von links unten nach rechts oben, solche auf der Substratoberseite durch eine Schraffur von links oben nach rechts unten gekennzeichnet.

Die Flossen 211, 221 der Flossenleitung bilden auf der Substratunterseite einen Schlitz 231. Das Substrat und die Flossen befinden sich in einem Hohlleiter 201.

Auf der anderen Seite des Substrats und senkrecht zur Schlitzrichtung ist ein Streifenleiter 241 auf das Substrat aufgebracht, der um eine Länge a über den Schlitz hinausragt. Der Abstand des Streifenleiters vom Schlitzende ist b.

Das Diodengehäuse 271 ist in einer Bohrung im Substrat befestigt und mit dem Streifenleiter 241 leitend verbunden. Die Versorgungsspannung für die Diode wird über ein in Streifenleitungstechnik realisiertes Tiefpaßfilter 281 zugeführt.

Bei dieser Anordnung wird die Streifenleitung mit der Flossenleitung über einen Streifen-Schlitzübergang verkoppelt. Dieser Übergang stellt bei einer geeigneten Wahl der Längen a und b einen Resonanzkreis dar, der die Frequenz bestimmt. Die Anpassung des Realteils der Diodenimpedanz geschieht durch die Wahl des Wellenwiderstands der Flossenleitung, d. h. durch eine geeignete Wahl der Schlitzweite, sowie durch einen Viertelwellenlängen-Transformator 291 auf der Streifenleitung direkt vor der Diode. Auf diese Weise kann bei einer durch a und b bestimmten Frequenz die Nennleistung des aktiven Elements ausgekoppelt werden.

Eine Weiterbildung dieser Lösung ist in der Figur 5b dargestellt.

Bei der Anordnung nach Fig. 5b wird die Länge a angenähert gleich null gewählt und die Streifenleitung wird mittels Durchkontaktieren 261 mit der metallischen Flosse 211 auf der anderen Substratseite verbunden. In diesem Fall wird der Resonanzkreis, der die Frequenz bestimmt, durch eine geeignete Wahl der Länge b (Abstand des Streifenleiters vom Schlitzende) sowie durch den Abstand d des Viertelwellenlängentransformators 291 vom Flossenleitungsschlitz 231 bestimmt. Die Anpassung des Realteils der Diodenimpedanz an die Last erfolgt wie beim Ausführungsbeispiel gemäß Fig. 5a.

Abschließend sollen einige Bemerkungen zum Betriebsverhalten gemacht werden. Mit allen Strukturen ist es möglich, die Nennleistung der Diode auszukoppeln. Der externe Gütefaktor und damit die Bandbreite sind vergleichbar mit den Werten, die in reiner Hohlleitertechnik erreicht werden. Damit liegt auch das Rauschen ähnlich niedrig. Der elektronische Durchstimmbereich der ersten Struktur beträgt typisch 5 bis 10 %.

Es wurde jeweils angegeben, welche Parameter einen Schwingkreis bilden bzw. die Frequenz festlegen und welche Parameter zur Anpassung an die Last geeignet bemessen werden müssen. Mit diesem Wissen ist es fachmännisches können, die tatsächlichen Längen für einen konkreten Fall zu bestimmen. Deshalb wird hierauf nicht näher eingegangen.

Für die beiden letzten Ausführungsbeispiele für einen Oszillator, der sich besonders vorteilhaft in Flossenleitungstechnik realisieren läßt, wird anhand der Fig. 6 und 7 die Funktionsweise erläutert.

Beiden Ausführungsbeispielen gemeinsam ist ein Koppler 403 mit vier Anschlüssen 203, 303, 703, 803. Als Koppler eignet sich der anhand der Fig. 3 erläuterte Kopper. Beim Ausführungsbeispiel nach Fig. 6 ist der Anschluß 303 und beim Ausführungsbeispiel nach Fig. 7 ist der Anschluß 203 mit dem Oszillatoranschluß des Kopplers 2 (Fig. 1) verbunden.

An zwei weitere Anschlüsse 703, 803 des Kopplers 403 (Fig. 6, 7) sind jeweils Varakter-Dioden 503, 603 angeschlossen. Die eine Varakterdiode 503 wird zur Einstellung der Frequenz, die andere 603 zur Einstellung der Leistung verwendet. Wird keine Durchstimmbarkeit bzw. keine Modulation gewünscht, dann wird an beide Varakterdioden eine solche Vorspannung angelegt, daß man die gewünschten Werte erhält. Soll der Oszillator durchstimmbar bzw. modulierbar sein, dann werden zur Steuerung der Frequenz bzw. der Leistung die Vorspannungen für die Varakterdioden geeignet geändert.

Durch die Wahl des Koppelverhältnisses kann man die Empfindlichkeit der Einstellparameter, d. h. die Empfindlichkeit der Frequenz- bzw. Amplitudeneinstellung, einstellen.

Da die beiden Vorspannungen für die beiden Dioden voneinander unabhängig gesteuert werden können, ist die Frequenzeinstellung von der Leistungseinstellung entkoppelt.

An einen weiteren Anschluß 203 des Kopplers ist ein aktiver Zweipol angeschlossen. Als aktives Element hierfür eignet sich eine Gunn-Diode.

Beim einen Ausführungsbeispiel gemäß Fig. 6 ist der vierte Anschluß 303 des Kopplers der Ausgang A des Oszillators, d. h. dieser ist mit dem Koppler 2 (Fig. 1) verbunden.

Beim anderen Ausführungsbeispiel gemäß Fig. 7 ist der vierte Anschluß 303 des Kopplers 403 mit einer Impedanz 103 abgeschlossen. Die Impedanz Zo ist so gewählt, daß sie gleich dem Wellenwiderstand des Kopplers ist.

In diesem Fall ist der Anschluß 203 des Kopplers 403 nicht nur mit dem aktiven Zweipol verbunden, sondern dieser Anschluß ist gleichzeitig auch der Ausgang A des Oszillators, d. h. dieser ist mit dem Koppler 2 (Fig. 1) verbunden.

Die Dioden können mit den Flossenleitungen des Kopplers wie anhand der Fig. 4 bis 5 erläutert verbunden werden, oder, wenn kein Diodengehäuse vorgesehen ist, direkt auf die Flossen aufgebondet werden.

Diese Schaltung ist für unterschiedliche Anwendungen geeignet. Sie kann einfach an sich bei einer konkreten Anwendung ergebenden Forderungen angepaßt werden. Bei speziellen Radargeräten beispielsweise sind zwischen dem Koppler 2 und den Dioden bzw. dem Oszillator Schalter eingefügt. Dies wird durch weitere Flossenleitungen, in die schaltbare Dioden eingefügt sind, realisiert.

Zur Realisierung der Antenne ist der Schlitz der Flossenleitung des Kopplers hornförmig aufgeweitet (Vivaldi-Struktur). Im übrigen gelten bei der Auslegung die von Hohlleiterantennen her bekannten Kriterien.

**Patentansprüche**

1. Sender/Empfänger-Modul, der beim Empfangsbetrieb ein ZF-Signal und beim Sendebetrieb das Sendesignal abgibt, mit einem Oszillator (1), der beim Sendebetrieb als Signalquelle und beim Empfangsbetrieb als Mischer-Oszillator verwendet wird, mit einem Koppler (2) oder einem magischen T mit vier Anschlüssen, von denen einer mit dem Oszillator verbunden ist, einer mit einer Antenne (3) verbindbar ist und zwei mit jeweils einer Dode (4, 4') verbunden sind, bei dem die beiden Dioden beim Sendebetrieb als Modulator und beim Empfangsbetrieb als Mischer verwendet werden, und mit einer Antenne dadurch gekennzeichnet, daß der Oszillator, der Koppler bzw. das magische T und der Modulator/Mischer in Flossenleitungstechnik realisiert sind, daß der in Flossenleitungstechnik realisierte Oszillator eine in einem Gehäuse angeordnete Diode als aktives Element und ein Impedanztransformationsnetzwerk zur Anpassung der Diode an eine Last und zur Bestimmung der Frequenz enthält, daß das Diodengehäuse (271) in dem Substrat, auf dem die Flossen (211, 221) der Flossenleitung aufgebracht sind, befestigt ist, daß auf der den Flossen gegenüberliegenden Seite des Substrats und angenähert senkrecht zu dem von den Flossen gebildeten Schlitz (231) der Flossenleitung eine Streifenleitung (241) aufgebracht ist, und daß das Diodengehäuse (271) mit dem Streifenleiter (241) leitend verbunden ist.

2. Sender/Empfänger-Modul, der beim Empfangsbetrieb ein ZF-Signal und beim Sendebetrieb das Sendesignal abgibt, mit einem Oszillator (1), der beim Sendebetrieb als Signalquelle und beim Empfangsbetrieb als Mischer-Oszillator verwendet wird, mit einem Koppler (2) oder einem magischen T mit vier Anschlüssen, von denen einer mit dem Oszillator verbunden ist, einer mit einer Antenne (3) verbindbar ist und zwei mit jeweils einer Diode (4, 4') verbunden sind, bei dem die beiden Dioden beim Sendebetrieb als Modulator und beim Empfangsbetrieb als Mischer verwendet werden, und mit einer Antenne dadurch gekennzeichnet, daß der Oszillator, der Koppler bzw. das magische T und der Modulator/Mischer in Flossenleitungstechnik realisiert sind, daß der in Flossenleitungstechnik realisierte Oszillator eine in einem Gehäuse (500) angeordnete Diode als aktives Element und ein Impedanztransformationsnetzwerk, zur Anpassung der Diode an eine Last und zur Bestimmung der Frequenz enthält, daß der Hohlleiter (100) der Flossenleitung mit einem Sperrbereichshohlleiter verbunden ist, daß die Flossen (200) der Flossenleitung in den Sperrbereichshohlleiter (400) hineinragen, daß das Diodengehäuse (500) im Sperrbereichshohlleiter angeordnet und mit der Ober- oder Unterseite des Sperrbereichshohlleiters leitend verbunden ist, und daß zur Festlegung der Frequenz und zur Anpassung der Diode an die Last der Abstand (1) zwischen Flossenende und Diodengehäuse und/oder die Breite des Schlitzes zwischen den Flossen sowie die Kapazität im Sperrbereichshohlleiter entsprechend gewählt sind.

3. Sender/Empfänger-Modul nach Anspruch 1, dadurch gekennzeichnet, daß der Streifenleiter (241, Fig. 5b) gerade soweit über den Schlitz (231) der Flossenleitung hinausragt, daß der Streifenleiter (241, 261) mit der Flosse (211) auf der gegenüberliegenden Substratseite leitend verbindbar ist und daß diese Verbindung (261) vorhanden ist, daß die Streifenleitung in einem bestimmten Abstand (d) vom Schlitz (231) zu einem Viertelwellenlängen-Transformator (291) ausgebildet ist, und daß dieser bestimmte Abstand (d), der Abstand (b) der Streifenleitung (241) vom Schlitzende und die Schlitzbreite der Flossenleitung entsprechend der gewünschten Frequenz und der Impedanz der Last gewählt sind.

4. Sender/Empfänger-Modul nach Anspruch 1, dadurch gekennzeichnet, daß der Streifenleiter (241, Fig. 5a) ein bestimmtes Stück (a) über den Schlitz (231) hinausragt und daß die Länge dieses Stücks (a), der Abstand (b) der Streifenleitung vom Schlitzende und die Schlitzbreite der Flossenleitung entsprechend der gewünschten Frequenz und der Impedanz der Last gewählt sind.

5. Sende/Empfänger-Modul nach einem der Ansprüche 1 bis 4, dadurch gekennzeichnet, daß auch die Antenne (3) in Flossenleitungstechnik realisiert ist.

**Claims**

1. Transmitter-receiver module providing an IF signal when receiving, and the transmitter signal when transmitting, and comprising an oscillator (1) used as a signal source during transmission and as a local oscillator during reception, a coupler (2) or a magic T having four terminals one of which is connected to the oscillator, another one is connectable to an antenna (3), and each of the remaining two is connected to a diode (4, 4'), the two diodes being used as a modulator during transmission and as a mixer during reception, and an antenna, characterized in that the oscillator, the coupler or the magic T, and the mixer-modulator are implemented in fin-line form, that the fin-line oscillator contains a diode housed in a package and used as an active element, and an impedance-matching network for matching the diode to a load and for determining the frequency, that the diode package (271) is mounted in the substrate on which the fins (211, 221) of the fin line are deposited, that a stripline (241) is deposited on the side of the substrate opposite the fins and at approximately right angles to the slot (231) formed by the fins, and that the diode package (271) is electrically connected to the stripline (241).

2. Transmitter-receiver module providing an IF signal when receiving, and the transmitter signal when transmitting, and comprising an oscillator (1) used as a signal source during transmission and as a local oscillator during reception, a coupler (2) or a magic T having four terminals one of which is connected to the oscillator, another one is connectable to an antenna (3), and each of the remaining two is connected to a diode (4, 4'), the two diodes being used as a modulator during transmission and as a mixer during reception, and an antenna, characterized in that the oscillator, the coupler or the magic T, and the mixer-modulator are implemented in fin-line form, that the fin-line oscillator contains a diode housed in a package (500) and used as an active element, and an impedance-matching network for matching the diode to a load and for determining the frequency, that the waveguide (100) containing the fin line is connected with a cutoff waveguide (400), that the fins (200) of the fin line extend into the cutoff waveguide (400), that the diode package (500) is disposed in the cutoff waveguide and electrically connected to the top or bottom side of the cutoff waveguide, and that, to determine the frequency and match the diode to the load, the distance (l) between the fin ends and the diode package and/or the width of the slot between the fins as well as the capacitance in the cutoff waveguide are chosen in a suitable manner.

3. A transmitter-receiver module as claimed in claim 1, characterized in that the stripline (241, Fig. 5b) extends beyond the slot (231) of the fin line to such a point that the stripline (241, 261) is electrically connectable to the fin (211) on the opposite side of the substrate, that such a connection (261) is present, that the stripline forms a quarter-wave transformer (291), at a given distance (d) from the slot (231), and that this given distance (d), the distance (b) of the stripline (241) from the end of the slot, and the slot width of the fin line are chosen in accordance with the desired frequency and the impedance of the load.

4. A transmitter-receiver module as claimed in claim 1, characterized in that the stripline (241, Fig. 5a) extends a given distance (a) beyond the slot (231), and that this given distance (a), the distance (b) of the stripline from the end of the slot, and the slot width of the fin line are chosen in accordance with the desired frequency and the impedance of the load.

5. A transmitter-receiver module as claimed in any one of claims 1 to 4, characterized in that the antenna (3) is also implemented in fin-line form.

**Revendications**

1. Module émetteur-récepteur fournissant un signal FI, en réception, et le signal d'émission, en émission, comprenant un oscillateur (1) utilisé comme source de signal à l'émission et comme oscillateur local à la réception, un coupleur (2) ou un T magique comportant quatre accès dont un qui est connecté à l'oscillateur, un qui est connectable à l'antenne (3) et deux qui sont respectivement connectés à une diode (4, 4'), les deux diodes étant utilisées comme modulateur à l'émission et mélangeur à la réception, et une antenne, caractérisé en ce que l'oscillateur, le coupleur ou le T magique et le modulateur/mélangeur sont réalisés par la technique des lignes à fente, en ce que l'oscillateur à ligne à fente comprend une diode disposée dans un boîtier comme élément actif et un réseau de transformation d'impédance, pour l'adaptation de la diode à une charge et pour le réglage de la fréquence, en ce que le boîtier de diode (271) est fixé dans le substrat sur lequel les pistes (211, 221) de la ligne à fente sont déposées, en ce qu'une ligne en bande (241) est déposée sur la face du substrat opposée à celle desdites pistes et approximativement à angle droit avec la fente (231) formée par les pistes et en ce que le boîtier de diode (271) est électriquement connecté à la ligne en bande (241).

2. Module émetteur-récepteur fournissant un signal FI, en réception, et le signal d'émission, en émission, comprenant un oscillateur (1) utilisé comme source de signal à l'émission et comme oscillateur local à la réception, un coupleur (2) ou un T magique comportant quatre accès dont un qui est connecté à l'oscillateur, un qui est connectable à l'antenne (3) et deux qui sont respectivement connectés à une diode (4, 4'), les deux diodes étant utilisées comme modulateur à l'émission et mélangeur à la réception, et une antenne, caractérisé en ce que l'oscillateur, le coupleur ou le T magique et le modulateur/mélangeur sont réalisés par la technique des lignes à fente, en ce que l'oscillateur à ligne à fente comprend une diode disposée dans un boîtier (500) comme élément actif et un réseau de transformation d'impédance, pour l'adaptation de la diode à une charge et pour le réglage de la fréquence, en ce que le guide d'onde (100) de la ligne à fente est connecté à un guide d'onde de coupure (400), en ce que les pistes (200) de la ligne à fente s'étendent dans le guide d'onde de coupure (400), en ce que le boîtier de diode (500) est disposé dans le guide d'onde de coupure et est électriquement connecté à la paroi supérieure ou inférieure du guide d'onde de coupure et en ce que, pour déterminer la fréquence et adapter la diode à la charge, on choisit une distance appropriée (1) entre les extrémités des pistes et le boîtier de diode et/ou une largeur appropriée de la fente entre les pistes, de même qu'une valeur appropriée de la capacitance du guide d'onde de coupure.

3. Module émetteur-récepteur conforme à la revendication 1, caractérisé en ce que la ligne en bande (241, fig. 5b) s'étend au-delà de la fente (231) de la ligne à fente au point que la ligne en bande (241, 261) soit électriquement connectable à la piste (211) de la face opposée du substrat, en ce que cette connexion (261) est effectuée, en ce que, à une distance donnée (d) de la fente (231), la ligne en bande forme un transformateur en quart d'onde (291) et en ce que, cette distance donnée (d), la distance (b) entre la ligne en bande (241) et l'extrémité de la fente et la largeur de la fente de la ligne à fente sont choisies en fonction de la fréquence désirée et de l'impédance de la charge.

4. Module émetteur-récepteur conforme à la revendication 1, caractérisé en ce que la ligne en bande (241, fig. 5a) s'étend sur une distance donnée (a) au-delà de la fente (231) et en ce que, cette distance donnée (a), la distance (b) entre la ligne en bande (241) et l'extrémité de la fente et la largeur de la fente de la ligne à fente sont choisies en fonction de la fréquence désirée et de l'impédance de la charge.

5. Module émetteur-récepteur conforme à l'une des revendications 1 à 4, caractérisé en ce que l'antenne (3) est réalisée par la technique des lignes à fente.

Fig.1

ZF, Modulationssignale

Fig.2

Fig.6

Fig.7

Fig.3

Fig.4a

Fig.4b

Fig.5a

Fig.5b

2